# EUROPEAN PATENT SPECIFICATION

(11) **EP 1 426 885 B1**
(45) Date of publication and mention of the grant of the patent: **04.01.2017**
(21) Application number: 02258375.1
(22) Date of filing: 04.12.2002
(51) Int. Cl.: G06F 17/50

(54) **Generation of a multiplicity of parameterised HDLs**
Erzeugung einer Vielzahl von parametrisierten HDLs
Génération d'une multiplicité de HDLs paramétrisés

(43) Date of publication of application: 09.06.2004
(73) Proprietor: Mentor Graphics Corporation, Wilsonville, OR 97070-7777 (US)
(72) Inventor: Hill, Christopher, Chandlers Ford, Hampshire SO53 4LD (GB); Rinderknecht, Thomas, Tualatin, OR 97062 (US); Mahadevan, Subramanian, Wilsonville, OR 97070 (US)
(74) Representative: Sessford, Russell

(56) References cited:
- WO-A-02/13024
- WO-A-02/43463
- WO-A-02/084538
- US-A- 6 135 647
- US-B1- 6 401 230
- US-B1- 6 446 251

## Description

### Background to and Summary of the Invention

This invention relates to a method of generating a Hardware Description Language.

A Hardware Description Language (HDL) is a computer programming language used for the design of integrated circuits to allow electronic design and gate level simulation which obviates the need to physically design and build digital systems such as integrated circuits - an expensive proposition. Examples of hardware description languages are Verilog (IEEE Standard Hardware Description Language Based on the Verilog® Hardware Description Language - IEEE Standard 1364-1995) and VHDL, which started as a U.S. Department of Defence developed and mandated language for hardware description, now standardised as IEEE Std 1076-1997.

An HDL behavioural description is an abstraction of how a digital system works described with HDL in the following manner: the function of the digital system is described in terms of its inputs but no effort is made to describe how the digital system is implemented in terms of logic gates. An HDL process is the basic essence of the HDL behavioural description. A process can be thought of as an independent concurrent thread of control. An HDL module or entity is a self-contained block of HDL descriptions that can be reused through instantiation. HDL processes are an integral part of an HDL module/entity. HDL modules/entities contain processes and instantiations of other modules/entities. An HDL module corresponds to the definition of a module in the Verilog HDL. HDL entity corresponds to the definition of entity in the VHDL and any Architecture that implements the functionality behind the interface described by the entity. The terms HDL module and HDL entity are used interchangeably throughout this description. An HDL gate is an HDL module/entity which describes a generic logic function or technology specific logic function. An HDL object is a self-contained independent block within the HDL description that can be reused through instantiation. HDL objects can be defined explicitly and implicitly. Explicit HDL objects are formally defined within the HDL description. Examples of explicit HDL objects are HDL module/entities and HDL gates. Implicit HDL objects are described in a non-HDL (HDL tool specific) format or implied through the internal data structure of a HDL tool.

Whilst this description explicitly refers to digital systems, it should be understood that the HDL technology is equally used to generate HDL for analogue systems.

Verilog HDL started as a language designed, by Phil Moorby, in 1983/4 with the specific intent of making it easy for people to describe the behaviour of electronic circuits (primarily digital logic) at a number of levels. The lowest level is the switch level, which models the hardware as an interconnected network of switches, of various types, and charge sources/sinks. The highest level is the behavioural level. At this level the model is in terms of the response of the system to externally and internally generated stimuli, using high level procedural flow of control descriptions. Just below this level is the register transfer level (RTL), where the description is less abstract and more closely related to real hardware. It is this RTL level and lower levels that can be understood by current synthesis tools which translate from an abstract hardware description into a real technology targeted gate level description with hopefully equivalent behaviour. The goal of the Verilog language was to make it easy to describe circuitry and to model digital circuits. In 1990 the then technology owners placed Verilog into the public domain and two years later work began to establish the language as an IEEE standard.

VHDL on the other hand came from the U.S. Department of Defence (DOD) need to be able to standardise and mandate a hand off and archival description format for their contractors. At that time their contractors had free choice of development environments for their Very High Speed Integrated Circuit (VHSIC, the V of VHDL) contracts. This made it difficult for the DOD to exchange information with and between its contractors. Also, going back to an archived design, some time after project completion, was problematic since technology moved so fast that the tools used with that design were probably obsolete and no longer available. The contract to develop the initial VHDL description was awarded in 1983. The committee developing the language decided to follow the pattern, for a fair amount of the structure and nature of the language, on the good work already done for the ADA programming language, another DOD standard. The resulting language is exceedingly feature rich (complex), even idiosyncratic in places. The nature of the language is to deal in abstractions that only become totally concrete when a description is compiled and globally, statically, elaborated. For example, information flows from place to place as a signal, in a manner defined by the standard. However, the exact meaning of the information in the signal can only be determined by inspecting the type definition of the signal and then inferring the semantics of the type and its interactions with other types. VHDL is an extremely flexible language.

Verilog HDL is very close to the actual hardware, dealing at its lower level in terms of switches and charge sources/sinks and at its higher levels in terms of logical data values (0s and 1s) and how they interact. VHDL is a complex and cumbersome beast, only through the use of a standard logic type package does the language start to reflect real logical behaviour. For a novice, with experience of digital logic design, Verilog HDL is far faster to learn than VHDL and the standard type packages. The flexibility of VHDL can easily become a burden.

Also, the way the two languages are used is greatly shaped by the tools that are used to process the languages. One of the main reasons for generating design descriptions at the register transfer level (RTL) is to pass into automated, technology mapping, gate level synthesis tools. Such tools take the RTL and generate a network of technology gate elements, targeted to a specific vendor's manufacturing technology. Whereas one used to do design work at the transistor level and then the gate level (using off the shelf collections of transistors packaged into a gate, with defined behaviour) with today's design sizes it is usually totally uneconomical to do this (except for small performance critical regions or other very limited areas). Hence the use of synthesis tools to generate the gate level model - ready to hand off to further design phase processing and subsequent downstream processing such as the IC manufacturing process.

These synthesis tools have their own idiosyncrasies and limitations on the portions of the input languages that they recognise and can process. One may need to describe things in particular ways to influence the tools to generate the desired gate level representation for a particular description. Since the input language processing for both VHDL and Verilog HDL were developed independently the metaphor and idiom that works for one language may not work for the other - ignoring the underlying language differences. One such synthesis tool is Design Compiler, from Synopsys - this has a front end (HDL Compiler) for reading Verilog HDL and one (VHDL Compiler) for reading VHDL. The Verilog HDL front end was brought to market first with the VHDL front end after.

### Summary of the Prior Art

There are a number of situations where an Electronic Design Automation (EDA) application needs to generate a Hardware Description Language (HDL). It is quite normal for such an application to be required to be able to output the HDL in a variety of languages, such as Verilog HDL (IEEE Std 1364), VHDL (IEEE Std 1076) or System C. To be able to do this the EDA application needs to contain either dedicated program logic to generate the HDL in the required output languages; the ability to generate an intermediate language neutral representation of the intended output and then translate the neutral format into the target HDL output language; or some capability between the two.

The two extremes presented above have their own significant advantages and disadvantages. For example, developing and maintaining dedicated program logic for individual generators for each HDL is a costly process which obtains no synergy between the generators. However, the exact style and form of the output HDL is predictable and can be controlled independently for each required HDL output language. This allows idioms natural for each language and downstream tool to be used.

Generating an intermediate neutral representation of the HDL and then translating into the target HDL takes advantage of the synergy between the HDLs. However, the exact style and form of the output HDL can not be controlled. It may be that the desired HDL modelling approach for one HDL is different to the others. Let us take the example of sensed outputs: VHDL does not allow the value of an output signal to be sensed within a block, whereas it is perfectly possible in Verilog HDL. This results in the need for a temporary internal signal and buffer to drive the output in VHDL that is not needed in Verilog HDL, if a signal drives both an output and other internal logic.

It should also be remarked that both of these extreme approaches and the variants between them typically have one major problem. The knowledge required to generate the HDLs is encoded into the fabric of the application, usually in the language of the applications implementation. This is often far removed from the HDL languages which are to be generated. This distance adds to the complexity of developing and maintaining an EDA application. It makes it hard to accommodate changes and difficult, if not impossible, for those outside of the development team to make changes to the HDL generation process.

Also, the current standard practice is to generate fixed HDLs, depending on the parameters of the generation process which control the generation. However, these parameters do not remain part of the output HDL being generated, leading to inflexibility if the parameters are to be altered.

US6,401,230 discloses software models associated with megafunctions written in any hardware description language to provide a higher level of parameterisation. To the user, the software models present a "wizard" interface allowing selection or setting of any number of important parameters for a particular megafunction. To the design compiler, a parameterised megafunction generated via the plug in appears to be a non-parameterised function of the type that may be easily be handled by a standard hardware description language compiler (such as a VHDL or Verilog compiler).

WO02/43463 discloses an internet hardware description code generating system which receives input parameters from a user, uses the input parameters to generate one or more hardware description language files and transmit the hardware description language files to the user.

### Objects of the Invention

It is an object of the present invention to seek to provide a mechanism and approach that allows the generation by an EDA application of a multiplicity of HDLs where the synergy inherent in the commonalties between the various HDLs are exploited whilst retaining the ability to generate the other parts of the output HDL in a style and form that is appropriate for a target HDL.

The mechanism and approach also seeks to allow the parameters used in the generation process to be used both at generation time and to remain, optionally, within the structure of the output HDL. Furthermore, whilst exploiting the common features between the output HDLs an approach has been developed that allows elements of connectivity information to be captured and their description incorporated at an abstract level, independent of the details of the HDL to be generated.

### Summary of the Invention

Whereas the current state of the art HDL generation facilities as described above in the summary of the prior art section encode the generation of the HDL within the application, the present invention separates out these generators from the application. A generation framework is provided that can be invoked from the application and which then allows the generators to be expressed as a set of totally separate entities. When using the generation framework, the application passes information to the framework that defines, amongst other things, how to locate the generators and what parameters are to be passed into the generators.

Aspects of the present invention are recited by the appended claims.

### Detailed Description of the Best Mode of the Invention

The present invention will be discussed below in the context of a built-in self test architecture.

The application is "LBISTArchitect" it is a logic built in self test (BIST) insertion and generation application. The inputs to the whole LBISTArchitect insertion and generation flow are a gate level netlist, for the core to be BISTed and a technology library that defines the gate level technology being used. There are various stages that need to be performed to get the core to the BIST ready state, ready to be coupled to a user's configuration of BIST controller. To form a BISTed core. The phase of the LBISTArchitect run that generates the BISTed core, including the BIST controller, is called the BIST controller synthesis phase. The phases that get the core ready for this are called the BIST ready phases.

The logic built-in self test architecture requires input in the form of a VHDL entity or a Verilog model. Additionally, built-in self test commands can be input to the application in the form of batch command files.

The LBISTArchitect BIST controller synthesis phase produces the following outputs in response to the inputs:
a VHDL RTL entity and architecture or a Verilog RTL module of the BIST circuitry, at a hierarchical level above the VHDL entity or Verilog module of the user's core which was used as the input. This new level of hierarchy contains the BIST circuitry as well as the parameters used to define that circuitry - i.e. the core design; and a top-level VHDL RTL entity or Verilog RTL model of the new hierarchical block which can be used by other applications to generate boundary scans.

The subject matter of the present application is concerned with the VHDL entity or Verilog module inputs passing through the LBISTArchitect bist controller synthesis phase and resulting in the output of a requested hardware description language model comprising the hardware description language at a register transfer level, in either Verilog HDL or VHDL.

The VHDL entity and/or Verilog models are standard hardware description languages which define a hardware system. The definition of the hardware system can be considered as having a core and a collar.

The core is the user's initial gate level circuit description, as modified by the LBISTArchitect BIST ready phase to make it suitable to couple to the logic BIST controller. The collar takes this BIST ready core and places it at the same hierarchical level as the generated BIST controller, connecting it to and through the BIST controller and to the interface signals of the collar. The additional control signals required by the BIST controller are also added to the collar. The collar can then be viewed as a BISTed core, the core with a BIST capability integrated into it.

In the most basic terms, the invention resides in the provision of a method for generating a bespoke hardware definition language from an input which is recognisable as a Verilog language but is in fact Verilog-like, and which can parameterise Verilog model files to modify the behaviour of the device modelled by the output hardware description language. The Verilog-like inputs include further functionality over and above the standard Verilog language by enhancing the Verilog language syntax.

In accordance with one embodiment of the present invention, the EDA application includes generators to generate a Hardware Description Language (HDL) in a number of required output languages in response to a Verilog-like input. The Verilog-like input is recognisable as a Verilog HDL but includes enhanced syntax in the form of extensions to the recognised standard syntax given in IEEE Standard 1364-1995.

The output language is preferably selected by the evaluation of an execution parameter during the execution of the generator but may also be selected by a configuration file, the content of which can be considered to be part of the set of execution parameters. Thus, it should be appreciated that it is possible for other elements to have control over the selection of the output language other than just the execution parameters (concrete or global).

### The extensions comprise:

Concrete parameters - Concrete parameters form part of the set of execution parameters, as described below - on page 136 of the IEEE Standard 1364-1995, the definition of module_item is extended by adding the BNF term "|concrete_parameter_declaration". This BNF term is defined as follows:
concrete_parameter_declaration ::=
   concrete list_of_concrete_param_declarations ;
list_of_concrete_param_declarations ::=
   concrete_param_declaration
   | concrete_param_declaration {, concrete_param_declaration }
concrete_param_declaration ::=
   *concrete*_*parameter*_identifier

The generator's interface contains zero or more concrete parameter declarations. The name of each concrete parameter must be unique within the set of identifiers declared within the generator.

Global parameters - Global parameters form part of the set of execution parameters, as described below - the importation of a global parameter is done by extending the module item definition on page 136 of the IEEE Standard 1364-1995 by adding the term "|global_parameter_declaration" with this term being defined by the following:
global_parameter_declaration ::=
   global list_of_global_param_declarations ;
list_of_global_param_declarations ::=
   global_param_declaration
   | global_param_declaration {, global_param_declaration }
global_param_declaration ::=
   *global_parameter_*identifier

The generators interface can contain zero or more global parameter declarations. The names of the global parameters imported by the interface of the generator must be unique within the set of identifiers of the generator.

Net declarations - VHDL type annotation, for nets, is achieved by taking a subset of the definition of net_declaration, from page 142 of the IEEE Standard 1364-1995 and extending it, supporting only two net types "wire" and "reg" thus:
net_declaration ::=
   net_type [vhdl_type] [range] list_of_net_variable
net_type **::= wire** | **reg**
list_of_net_variables ::=
   net_variable
   | net_variable {, net_variable }
net_variable ::= *net*_identifier
vhd1_type **::= [constrained] "***vhdl*_*type*_identifier"

The net names declared within a generator must be unique within the set of identifiers of the generator. The optional VHDL type string is the definition of the VHDL type of the net. The optional constrained qualification denotes that the net is a fully constrained VHDL type and as such when generating the VHDL net declaration, in the output VHDL, no range constraint should be used.

Port tagging - Port (interface signal) tagging (or labelling) is achieved by taking the definition of input, output and inout ports found on page 142 of the IEEE Standard 1364-1995 and turning them into a single module_port_declaration and extending it thus:
module_port_declaration ::=
   port_direction [vhdl_type] [range] list_of_io_variables [list_of_tags] ;
list_of_io_variables ::= io_variable
   | io_variable {, io_variable }
io_variable ::= *port*_*name*_identifier
list_of_tags ::= tag | {tag {, tag}}
tag ::= " *tag*_*name*"
port_direction ::= **input** | **output** | **inout**

Zero or more tag names can be associated with a port declaration. If more than one port is declared in the port declaration, then each port has an associated set of tags.

Potential Port Declarations - The ability for an RTL generator to declare that a new port can come into existence, because of the activity of the "route" facility, propagating a signal up to the interface of the RTL generator, is achieved by adding the new "potential_port_declaration" to the set of module_items on page 136 of the IEEE Standard 1364-1995, with definition thus:
Potential_port_declaration ::= **potential** port_direction list_of_tags ;

The route command is not allowed to create a new port in the interface of an RTL generator unless the generator has explicitly declared that it can be done, using this declaration.

Component instances - as described from the bottom of page 136 of the IEEE Standard 1364-1995, component instances allow the default parameter values of the instanced modules to be modified, by providing an ordered module instance parameter value assignment definition, as described at in section 12.2.2 of the IEEE Standard 1364-1995, at the bottom of page 140. This mechanism is modified to use only named parameter bindings, in the same format that is used for named signal binding (see section 12.3.4 of the IEEE Standard 1364-1995 compared with section 12.3.3 for ordered port bindings). A parameter, either module or concrete, must have a value either passed in from the instance or defined in the underlying generator. Thus, the module_instance item, defined on page 137 of the IEEE Standard 1364-1995 becomes:
module_instance ::=
   *instance*_*name*_identifier [instance_parameter] list_of_module_instances;
instance_parameter ::=
   #(named_parameter_binding_list)
   | #()
named_parameter_binding_list ::=
   named_parameter_binding
   | named_parameter_binding {, named_parameter_binding }
named_parameter_binding ::=
   *. parameter_name*_identifier (constant_expression)
   | . *parameter*_*name*_identifier ( )
list_of_module_instances ::=
   actual_module_instance
   | actual_module_instance {, actual_module_instance }
actual_module_instance ::=
   *name*_*of*_*instance*_identifier [**DELAY**_**PORT**_**CHECK**] ( [instance_port_list])
instance_port_list ::=
   named_port_binding
   | named_port_binding {. named_port_binding }
named_port_binding ::= . *port*_*name*_identifier ([expression])

The optional DELAY_PORT_CHECK qualifier causes the checks that are normally performed on a instance to be postponed until after structural section of the generator has completed - thus allowing partially populated instances to be fully populated by the rest of the structure section. Normally an instance is checked to ensure that the correct port bindings are present and not malformed.

Instance Port Connection - in addition to being able to specify instance port bindings within the component instance, as described above, the module_item item, shown on page 136 of the IEEE Standard 1364-1995 is extended by the addition of the instance_port_connection, which is defined thus:
instance_port_connection ::=
   **connect** *instance_name_*identifier. *port_name*_identifier (expression) ;

This allows an expression to be bound to a port of an instance currently without a port binding.

Stub Construct - another way of describing a signal to an instance port binding is through the stub construct. This is another extension to the module_item item shown on page 136 of the IEEE Standard 1364-1995 and is defined this:
stub_wire_declaration ::=
   **stub** [stub_option] ["*stub_prefix_*identifier"]
   stub_port_list ["***stub_suffix**_*identifier"] ;
stub_option ::=
   stub_option_element
   | stub_option_element { stub_option_element }
stub_option_element ::= **reg | degenerate**
stub_port_list ::=
   stub_port_description
   | stub_port_description {, stub_port_description }
stub_port_description ::=
   *instance_name*_identifier [. tag] port_direction

The optional stub prefix and suffix identifiers allow one to specify a prefix and suffix string added to the name if the signals generated when applying the stub to those ports identified on the instance. If stub_port_description is only an instance name and direction then all unconnected ports, of the given direction, on the instance are stubbed. Otherwise only those with the given tag are stubbed. Stubbing a port causes a unique new signal to be generated and bound to the instance port. If the reg qualification is supplied then all signals associated with input ports are generated as reg signals, for Verilog. The degenerate option allows the stub command to degenerate silently in the case where the stub_port_list selects no instance ports; normally this is an error condition.

Route Options - a further way to provide instance port binding is through the route facility. This is a further addition to the module_item item of page 136 of the IEEE Standard 1364-1995 and is defined thus:
route_connection ::=
   **route** [route_option] route_list;
route_option ::=
   route_option_element
   | route_option_element { route_option_element }
route_option _element::= **reverse** | **degenerate**
route_list ::=
   route_element
   | route_element {, route_element }
route_element ::=
   ["*route_prefix*_identifier"] (route_clause)
   ["*route_suffix*_identifier"]
route_clause ::=
   route_from_port, route_to_list
route_from_port ::=
   route_port_description
route_to_list ::=
   route_port_description
   | route_port_description {, route_port_description }
route_port_description ::=
   tag port_direction
   | *port*_*name*_identifier
   *instance*_*name*_identifier.tag port_direction
   | *instance_name_identifier.port*_*name*_identifier

The route options control how the route facility operates. When reverse is specified the signal within an aggregation will be reversed when connected to a single vector port. The degenerate option allows the route command to behave silently in the case where the from_route_port description finds no unconnected ports to route. The route prefix and suffix identifiers of the route clause allow one to specify qualifiers that will be added to any signal names generated whilst evaluating the route.

In addition to the extensions described above, the Verilog HDL like language has been extended to allow the annotation of certain module items (parameter_declaration, net_declaration, reg_declaration, continuous_assign and module_instance) with comments that will be inserted into the output language file when HDL is generated. This is as opposed to the normal Verilog HDL comments that disappear during the processing of these regions. This is achieved by replacing these grammar items above with one that supports the annotation of comments. For example the module_item_declaration element module_instance is replaced with commented_module_instance, which is defined as:
commented_module_instance ::=
   **[COMMENT** comment_string] module_instance
comment_string ::=
   "string"
   | "string" {, "string" }

When generating the corresponding output HDL the comment strings are written out as comments, introduced with the appropriate single line comment preamble.

As well as comments, as described above, the following module_items (module_port_declaration, net_declaration, reg_declaration, continuous_assign, module_instance, instance_port_connection, stub_wire_declaration and route_connection) can be qualified with a conditional expression. When evaluating the module item it will be ignored unless the condition evaluates to the logical true value. This is achieved by taking these items in the module_item item and replacing them with a version that expresses the conditional form and references the original. For example the net_declaration is made conditional with the following:
conditional_net_declaration ::= [conditionality] net_declaration
conditionality ::=
   **if** constant_expression
   | **unless** constant_expression

This conditional qualification preferably supplements the comment annotation described above. However, the conditional qualification and the comment annotation are features that can be used independently of each other.

### The generators:

Each generator consists of a number of ordinary text files, an example of which is shown in Appendix A annexed hereto. Each file can be considered as describing how to generate at least one level of hierarchy within a respective output HDL. Within the description of a single level there are a number of distinct elements. These elements comprise: 1) a description of the interface that the generator presents to any other generator requiring its services; 2) a description of the HDL language neutral structure information for the generator - this description contains those entities that are common between the output HDLs and is presently restricted to signal declarations, signal assignments, the instantiation (see section 12.1.2 on page 136 of IEEE Standard 1364-1995) of lower level generators within the hierarchy and the interconnection of these lower level generators; and 3) a description of how to generate the HDL language-specific parts of the generator.

The language used for the first two parts (1 and 2) above is based on a subset of the standard Verilog HDL (IEEE Std 1364) which is conveniently broadly familiar to EDA design engineers. A number of simple extensions (as described above) to Verilog HDL are used to accommodate new behaviour and to facility the support for certain language dependent features as described below. The language used for the HDL language generation part (3) of the generator is the actual target output HDL to be generated.

If the facilities of the languages described above are insufficient then these languages can also be enclosed within the flow of control of another conventional programming language. Most simple parameterised generation can be achieved without resorting to such an outer level language. However, by the use of this outer level language far more complicated parameterisations can be achieved. In this example, Per1 is the outer language, although any other language could be used, such as, but not limited to, TCL, Python, lisp and scheme. Although all of these languages are interpreted this does not preclude the use of compiled languages (C, Java, C++, Pascal etc.). However, the use of compiled languages places another step (translation and compilation) between the writing of generators and their use.

The description of the interface that the generator presents to any other generator requiring its services allows the interface entities to be described such as: input, output, bi-directional signal interconnections and also parameters.

In the Verilog-like input, parameters are split into three classes:
1) module parameters which correspond to Verilog HDL parameters and VHDL generics. These parameters are preserved in the HDL that is generated for that level of the hierarchy in the output HDL. Using these parameters it is possible to alter the behaviour and meaning of the HDL after it has been generated. Module parameters are also termed persistent parameters because of their persistence (remaining presence) in the output HDL. For example, it is possible to change the size of a signal within the entirety of the HDL hierarchy;
2) concrete parameters which are passed through the hierarchy of generators, like the module parameters, but which are not emitted in the output HDLs; and
3) global parameters which are not passed through the generator hierarchy but are defined by the client application and explicitly imported by a generator that accesses them.
Concrete parameters and global parameters together comprise a set of parameters termed herein as execution parameters because they are evaluated during execution of the generator to control the execution of the generator but do not persist as a parameter in the output of the executed generator.

Concrete and global parameters are used to control those aspects of the generation process that result in a specific realisation of some aspect of the output HDL For example, an arithmetic and logic unit (ALU) can be generated in two flavours (with and without carry). The flavour is controlled by the concrete has_carry parameter. Each flavour can have any width of input and output, adjusted using the size module parameter. The two values of the has_carry concrete parameter give rise to two distinct realisations of the ALU, one with carry in and out and the other without these signals and the associated behaviour.

Once a concrete or global parameter has been defined in the interface, it can be used to control the meaning of the rest of the generator, through the use of conditionality clauses within the Verilog HDL-like languages. Also, the values associated with these parameters are available within the wrapper language, i.e. the "outer level" language too.

When evaluating a generator, the interface and structure information is used to build a hierarchical framework for the output HDL and the generators required for the various parts of the hierarchy. This information is then used to control the creation of the interface and structure part of the output HDL, the common parts, and the evaluation of the language specific parts, when writing the output HDLs.

As a consequence of the adoption of Verilog HDL as the basis for the language neutral information within the generators little specialist knowledge is required to understand most generators.

Because the generators are simple text files, not part of the fabric of the application, it becomes simple for people outside of the development team to make changes to them. These people could be in the field organisation or even the customer.

Since the author of the generator is able to craft the exact HDL they require, in the language specific parts of the generator, the resultant generated HDL will be exactly as they require it, without sacrificing the synergy within the language common features. It is simple to support divergent implementations for each output HDL.

This approach allows a skilled HDL author to concentrate on getting the HDL correct, without being distracted by too many details of the implementation language. They do not need to master some alien programming language or have to try and persuade some language neutral HDL representation to correspond to the HDL that they require. The author is in full control of the HDL that is important to them. It is simple to create HDL generators that result in HDL that gives the appearance of being hand coded and bespoke.

Another aspect of the invention provides a method of controlling access to the mechanism used to create or alter the generators. Because the generators are simple text files, that are familiar to one with an understanding of standard HDLs, it is important that control over any modifications to the generators is exercised otherwise unauthorised changes could be made causing end user doubt as to the authenticity and veracity of the generators. Further, if one is to avoid support problems it must be simple to verify the authenticity and veracity of the generators.

These two goals are addressed in two ways. The ability to provide a signature for a generator file, using a message digest algorithm, and the ability to encrypt the generator text file, from plain text to a file containing unintelligible data. When the generator file is read any encryption is stripped off and the rest of the file is read as normal, any signatures encountered are validated against the signature of the rest of the file.

Thus, by controlling the access to the mechanism used to create signatures and decode the encrypted generators it is possible to ensure the veracity of the generators without compromising the ability of authorised users to make changes to the generators.

A further aspect of the present invention provides a method of ensuring capacity for or compatibility with, within the language neutral interface, unsupported constructs and type conversion.

Although the HDL generators contain a language neutral description of certain elements of the HDL there can be, in some circumstances, cases where this language neutral representation is inadequate for a particular output HDL. One could constrain the language neutral language to conform the restrictions of the most constrained language. For example in VHDL one cannot sense the state of an output signal but this is not a problem in Verilog HDL. Preferred embodiments of the invention use the less restrictive Verilog representation. Prior to generating the VHDL output for the interface and structure information it is processed to translate any constructs that are not supported in VHDL into a form that can be used. Thus, sensed outputs are translated to an internal signal and an assignment to the output.

Another aspect of VHDL that can be problematic is that of signal typing and type conversion. One extension that has been made to the Verilog language used in the language neutral interface and structure blocks is to allow type information to be adorned on internal signals and interface signals. Normally no adornment is required, since the default types suffice. Before writing VHDL the types of signals and expressions are checked for compatibility and where necessary type conversions are introduced to ensure type correctness.

In this way the HDL generator author is not inconvenienced too much by the details of some of the fundamental differences between the output HDLs within the language neutral sections of the generator.

Yet another aspect of the present invention provides an HDL generation facility with the ability to create HDL generators that will generate HDL that interfaces to existing HDL provided by a user. In order to be able to do this it is required to be able to manage the connectivity between the HDL generator and the existing HDL. This requires the provision of an abstraction for the interface signals of the existing HDL and the ability to tie this abstraction to the signals realised within the HDL created by the generators.

This is done by the ability to specify simple abstract tags that can be associated with the interface signals of a generator and then some high level operations that can be performed using these tags, at the point of an instance of such a generator.

There are two distinct high level operations: Route - connect the interface signals of an instance to another instance or up to the interface of the current level of the hierarchy; and Stub - connect the interface signals of an instance to internal signals within the current level of the hierarchy.

By using a tag, the author of the HDL generator is isolated from the specific details of interface of the lower levels of hierarchy that the generator will be interacting with, other than specifying the conventions for signal tagging. If a tag selects a number of signals then they can be processed as an aggregation, to form a composite entity.

Again, the author of the generator is able to describe their intent without getting lost in the details of the implementation.

In the present specification "comprises" means "includes or consists of" and "comprising" means "including or consisting of".

The features disclosed in the foregoing description, or the following claims, or the accompanying drawings, expressed in their specific forms or in terms of a means for performing the disclosed function, or a method or process for attaining the disclosed result, as appropriate, may, separately, or in any combination of such features, be utilised for realising the invention in diverse forms thereof.

## Claims

1. A method of generating a hardware description language (HDL) for electronic design automation comprising the steps of:
providing a source of a hardware description language generator having at least two parameters: a persistent parameter being evaluated during execution of the generator and retained as a parameter in the output of the executed generator; and an execution parameter being evaluated during execution of the generator to control the execution of the generator but not persisting as a parameter in the output of the executed generator; and
executing the generator to provide an output hardware description language (HDL) in one of a plurality of output HDLs, the output HDL containing the persistent parameter which is capable of subsequent manipulation, wherein generator behaviour which is common within the output HDLs is described in the source once whereas generator behaviour which is not common to the output HDLs is described in accordance with the one of the plurality of output HDLs, and wherein the one of the plurality of output HDLs is selected by evaluation of the execution parameter.

2. A method according to Claim 1, wherein the execution process is controlled by the value of the execution parameter and determines the nature of the persistent parameter.

3. A method according to Claim 2, wherein the nature of the persistent parameter is whether the persistent parameter is present in the output and, if present, the effect that the persistent parameter has in the generator output.

4. A method according to Claim 1, wherein there are a plurality of execution parameters and at least one of the execution parameters determines which of the at least two parameters are present in the execution of the generator.

5. A method according to Claim 1, wherein there are a plurality of persistent parameters which are selectable by at least one of the execution parameters during execution of the generator for inclusion in the output of the generator.

6. A method according to Claim 1, wherein there are a plurality of execution parameters which are selectable by at least one of the execution parameters during execution of the generator.

7. A method according to Claim 1, wherein the source is in the form of a hardware description language (HDL).

8. A method according to Claim 7, wherein the HDL is based upon one from the group consisting of: Verilog HDL (IEEE Standard 1364-1995); VHDL (IEEE Standard 1076-1997); System C; and System Verilog.

9. A method according to Claim 1, wherein generator behaviour which is common within possible output HDLs is converted into the language of the output HDL by execution of the generator.

10. A method according to Claim 1, wherein the generator behaviour which is common contains a comment which is discarded during execution.

11. A method according to Claim 1, wherein the generator behaviour which is common contains an entry annotated with text, the entry being expressed as a comment in the output HDL by execution of the generator.

12. A method according to Claim 11, wherein the expressed comment in the output HDL is proximal to the HDL corresponding to the entry which was annotated.

13. A method according to Claim 9, wherein the conversion into the language of the output HDL is a one-to-one mapping step.

14. A method according to Claim 9, wherein the conversion into the language of the output HDL requires the addition of ancillary supporting HDL constructs to achieve equivalence.

15. A method according to Claim 14, wherein the ancillary supporting HDL construct comprises a conversion to and recitation of a VHDL type.

16. A method according to Claim 14, wherein the ancillary supporting HDL construct comprises a new internal signal and a buffer driving the output signal from that internal signal and occurrences of the original output signal usage within the generator are output using the internal signal.

17. A method according to Claim 1, wherein the natural idioms differ between the possible output languages and the generated output language produced has the appearance of having been created using the natural idioms of the output language by a skilled user of the output language.

18. A method according to Claim 1, wherein the output hardware description language is selectable to be in a designated output hardware description language.

19. A method according to Claim 18, wherein the output hardware description language is selected by the evaluation of an execution parameter during the execution of the generator.

20. A method according to Claim 18 wherein the output hardware description language is selected by a configuration file.

21. A method according to Claim 1, wherein the execution of the generator comprises a plurality of execution steps, the flow through which is controlled by an execution parameter during the execution of the generator.

22. A method according to Claim 1, wherein the generator requires an authentication signature to enable execution.

23. A method according to Claim 1, wherein the generator is encrypted to prevent unauthorized access.

24. A method of interfacing a parent and a child hardware description language generator comprising the steps of:
identifying the elements of the signal interface of the child generator;
labelling those elements in the child generator with which the parent generator may interact;
writing the parent generator in terms of the labelling applied to the child generator; and
executing the generators and, in the process of executing the generators, the labelling used within the parent generator is resolved with the labelling used in the child generator to allow the parent generator to use the signal interface of the child generator,
wherein at least one of the generators operates in accordance with the method of claim 1.

## Patentansprüche

1. Verfahren zum Erzeugen einer Hardwarebeschreibungssprache (HDL) zur Entwurfsautomatisierung elektronischer Systeme, umfassend die folgenden Schritte:
Bereitstellen einer Quelle eines Hardwarebeschreibungssprache-Generators aufweisend mindestens zwei Parameter: einen persistenten Parameter, der während der Ausführung des Generators ausgewertet und als Parameter in der Ausgabe des ausgeführten Generators zurückbehalten wird; und einen Ausführungsparameter, der während der Ausführung des Generators ausgewertet wird, um die Ausführung des Generators zu steuern, aber nicht als Parameter in der Ausgabe des ausgeführten Generators persistiert; und
Ausführen des Generators, um eine Ausgabe-Hardwarebeschreibungssprache (HDL) in einer einer Mehrzahl von Ausgabe-HDLs bereitzustellen, wobei die Ausgabe-HDL den persistenten Parameter enthält, der folglich manipuliert werden kann, worin das Generatorverhalten, das innerhalb der Ausgabe-HDLs üblich ist, in der Quelle einmal beschrieben ist, wohingegen das Generatorverhalten, das für die Ausgabe-HDLs nicht üblich ist, gemäß der einen der Mehrzahl von Ausgabe-HDLs beschrieben ist, und worin die eine der Mehrzahl von Ausgabe-HDLs durch Auswertung des Ausführungsparameters selektiert wird.

2. Verfahren nach Anspruch 1, worin der Ausführungsprozess durch den Wert des Ausführungsparameters gesteuert wird und die Art des persistenten Parameters bestimmt.

3. Verfahren nach Anspruch 2, worin die Art des persistenten Parameters darin besteht, ob der persistente Parameter in der Ausgabe vorliegt und, falls vorliegend, in der Wirkung, die der persistente Parameter in der Generatorausgabe hat.

4. Verfahren nach Anspruch 1, worin es eine Mehrzahl von Ausführungsparametern gibt und mindestens einer der Ausführungsparameter bestimmt, welcher der mindestens zwei Parameter in der Ausführung des Generators vorliegt.

5. Verfahren nach Anspruch 1, worin es eine Mehrzahl von persistenten Parametern gibt, die durch mindestens einen der Ausführungsparameter während der Ausführung des Generators für die Aufnahme in die Ausgabe des Generators selektierbar sind.

6. Verfahren nach Anspruch 1, worin es eine Mehrzahl von Ausführungsparametern gibt, die durch mindestens einen der Ausführungsparameter während der Ausführung des Generators selektierbar sind.

7. Verfahren nach Anspruch 1, worin die Quelle in Form einer Hardwarebeschreibungssprache (HDL) vorliegt.

8. Verfahren nach Anspruch 7, worin die HDL auf einer der aus folgenden bestehenden Gruppe beruht: Verilog HDL (IEEE-Standard 1364-1995); VHDL (IEEE-Standard 1076-1997); System C; und System Verilog.

9. Verfahren nach Anspruch 1, worin das Generatorverhalten, das innerhalb möglicher Ausgabe-HDLs üblich ist, durch Ausführung des Generators in die Sprache der Ausgabe-HDL umgesetzt wird.

10. Verfahren nach Anspruch 1, worin das Generatorverhalten, das üblich ist, einen Kommentar enthält, der während der Ausführung verworfen wird.

11. Verfahren nach Anspruch 1, worin das Generatorverhalten, das üblich ist, eine mit Text annotierte Eingabe enthält, wobei die Eingabe als Kommentar in der Ausgabe-HDL durch Ausführung des Generators ausgedrückt wird.

12. Verfahren nach Anspruch 11, worin der ausgedrückte Kommentar in der Ausgabe-HDL entsprechend der Eingabe, die annotiert wurde, proximal zur HDL ist.

13. Verfahren nach Anspruch 9, worin die Umsetzung in die Sprache der Ausgabe-HDL ein Eins-zu-Eins-Abbildungsschritt ist.

14. Verfahren nach Anspruch 9, worin die Umsetzung in die Sprache der Ausgabe-HDL die Hinzufügung zusätzlicher unterstützender HDL-Konstrukte zur Erzielung von Gleichwertigkeit erfordert.

15. Verfahren nach Anspruch 14, worin das zusätzliche unterstützende HDL-Konstrukte eine Umsetzung in und Rezitation eines VHDL-Typs umfasst.

16. Verfahren nach Anspruch 14, worin das zusätzliche unterstützende HDL-Konstrukt ein neues internes Signal und einen Puffer, der das Ausgabesignal von diesem internen Signal treibt, umfasst und Vorfälle einer Nutzung des ursprünglichen Ausgabesignals innerhalb des Generators unter Verwendung des internen Signals ausgegeben werden.

17. Verfahren nach Anspruch 1, worin die natürlichen Idiome je nach den möglichen Ausgabesprachen unterschiedlich sind und die erzeugte Ausgabesprache den Anschein hat, dass sie unter Verwendung der natürlichen Idiome der Ausgabesprache durch einen qualifizierten Benutzer der Ausgabesprache geschaffen wurde.

18. Verfahren nach Anspruch 1, worin die Ausgabe-Hardwarebeschreibungssprache so selektierbar ist, dass sie als eine designierte Ausgabe-Hardwarebeschreibungssprache vorliegt.

19. Verfahren nach Anspruch 18, worin die Ausgabe-Hardwarebeschreibungssprache durch die Auswertung eines Ausführungsparameters während der Ausführung des Generators selektiert wird.

20. Verfahren nach Anspruch 18, worin die Ausgabe-Hardwarebeschreibungssprache durch eine Konfigurationsdatei selektiert wird.

21. Verfahren nach Anspruch 1, worin die Ausführung des Generators eine Mehrzahl von Ausführungsschritten umfasst, deren Durchschreiten durch einen Ausführungsparameter während der Ausführung des Generators gesteuert wird.

22. Verfahren nach Anspruch 1, worin der Generator eine Authentifizierungssignatur erfordert, um die Ausführung zu ermöglichen.

23. Verfahren nach Anspruch 1, worin der Generator verschlüsselt ist, um unbefugten Zugriff zu verhindern.

24. Verfahren zur Verknüpfung eines Parent- und eines Child-Hardwarebeschreibungssprache-Generators, umfassend die folgenden Schritte:
Identifizieren der Elemente der Signalschnittstelle des Child-Generators; Kennzeichnen dieser Elemente im Child-Generator, mit dem der Parent-Generator zusammenwirken kann;
Schreiben des Parent-Generators in Bezug auf die auf den Child-Generator angewandte Kennzeichnung; und
Ausführen der Generatoren und, beim Vorgang des Ausführens der Generatoren, Bestimmen der innerhalb des Parent-Generators verwendeten Kennzeichnung mit der im Child-Generator verwendeten Kennzeichnung, um es dem Parent-Generator zu erlauben, die Signalschnittstelle des Child-Generators zu benutzen,
worin mindestens einer der Generatoren gemäß dem Verfahren nach Anspruch 1 arbeitet.

## Revendications

1. Procédé de génération d'un langage de description de matériel (HDL) pour une automatisation de conception électronique, le procédé comprenant les étapes consistant à :
fournir une source d'un générateur de langage de description de matériel ayant au moins deux paramètres : un paramètre persistant évalué pendant l'exécution du générateur et conservé en tant que paramètre en sortie du générateur exécuté ; et un paramètre d'exécution évalué pendant l'exécution du générateur pour contrôler l'exécution du générateur, mais non persistant en tant que paramètre en sortie du générateur exécuté ; et
exécuter le générateur pour fournir un langage de description de matériel (HDL) dans un HDL de sortie d'une pluralité de HDL de sortie, le HDL de sortie comportant le paramètre persistant pouvant être manipulé ultérieurement, le comportement de générateur commun aux HDL de sortie étant décrit une fois dans la source, et le comportement de générateur non commun aux HDL de sortie étant décrit conformément audit HDL de sortie de la pluralité de HDL de sortie, et le HDL de sortie de la pluralité de HDL de sortie étant sélectionné par évaluation du paramètre d'exécution.

2. Procédé selon la revendication 1, dans lequel l'étape d'exécution est contrôlée par la valeur du paramètre d'exécution et détermine la nature du paramètre persistant.

3. Procédé selon la revendication 2, dans lequel la nature du paramètre persistant dépend de si le paramètre persistant est présent dans la sortie, et, s'il est présent, de l'effet que le paramètre persistant a dans la sortie de générateur.

4. Procédé selon la revendication 1, comprenant une pluralité de paramètres d'exécution, au moins un des paramètres d'exécution déterminant lequel ou lesquels des au moins deux paramètres sont présents dans l'exécution du générateur.

5. Procédé selon la revendication 1, comprenant une pluralité de paramètres persistants pouvant être sélectionnés par au moins un des paramètres d'exécution pendant l'exécution du générateur en vue d'être inclus dans la sortie du générateur.

6. Procédé selon la revendication 1, comprenant une pluralité de paramètres d'exécution pouvant être sélectionnés par au moins un des paramètres d'exécution pendant l'exécution du générateur.

7. Procédé selon la revendication 1, dans lequel la source est sous la forme d'un langage de description de matériel (HDL).

8. Procédé selon la revendication 7, dans lequel le HDL est basé sur un langage du groupe constitué de : Verilog HDL (norme IEEE 1364-1995) ; VHDL (norme IEEE 1076-1997) ; SystemC ; et System Verilog.

9. Procédé selon la revendication 1, dans lequel un comportement de générateur qui est commun aux possibles HDL de sortie est converti en langage du HDL de sortie par l'exécution du générateur.

10. Procédé selon la revendication 1, dans lequel le comportement de générateur qui est commun contient un commentaire qui est rejeté pendant l'exécution.

11. Procédé selon la revendication 1, dans lequel le comportement de générateur qui est commun contient une entrée annotée avec du texte, l'entrée étant exprimée sous la forme d'un commentaire dans le HDL de sortie par l'exécution du générateur.

12. Procédé selon la revendication 11, dans lequel le commentaire exprimé dans le HDL de sortie est proche du HDL correspondant à l'entrée qui a été annotée.

13. Procédé selon la revendication 9, dans lequel la conversion dans le langage du HDL de sortie est une étape d'application injective.

14. Procédé selon la revendication 9, dans lequel la conversion dans le langage du HDL de sortie requiert l'ajout de constructions auxiliaires prenant en charge le HDL afin d'obtenir une équivalence.

15. Procédé selon la revendication 14, dans lequel la construction auxiliaire prenant en charge le HDL comprend une conversion en type VHDL et une récitation d'un type VHDL.

16. Procédé selon la revendication 14, dans lequel la construction auxiliaire prenant en charge le HDL comprend un nouveau signal interne et un tampon commandant le signal de sortie à partir de ce signal interne, et dans lequel les occurrences de l'utilisation du signal de sortie d'origine dans le générateur sont émises au moyen du signal interne.

17. Procédé selon la revendication 1, dans lequel les idiomes naturels diffèrent selon les possibles langages de sortie, et dans lequel le langage de sortie généré produit a l'apparence d'avoir été créé au moyen des idiomes naturels du langage de sortie par un utilisateur maîtrisant le langage de sortie.

18. Procédé selon la revendication 1, dans lequel le langage de description de matériel de sortie peut être sélectionné pour être dans un langage de description de matériel de sortie désigné.

19. Procédé selon la revendication 18, dans lequel le langage de description de matériel de sortie est sélectionné par l'évaluation d'un paramètre d'exécution pendant l'exécution du générateur.

20. Procédé selon la revendication 18, dans lequel le langage de description de matériel de sortie est sélectionné par un fichier de configuration.

21. Procédé selon la revendication 1, dans lequel l'exécution du générateur comprend une pluralité d'étapes d'exécution, le passage d'une étape à une autre étant contrôlé par un paramètre d'exécution pendant l'exécution du générateur.

22. Procédé selon la revendication 1, dans lequel le générateur requiert une signature d'authentification pour permettre l'exécution.

23. Procédé selon la revendication 1, dans lequel le générateur est crypté pour empêcher un accès non autorisé.

24. Procédé d'interfaçage d'un générateur de langage de description de matériel parent et d'un générateur de langage de description de matériel enfant, comprenant les étapes consistant à :
identifier les éléments de l'interface de signal du générateur enfant ;
marquer les éléments dans le générateur enfant avec lesquels le générateur parent peut interagir ;
écrire dans le générateur parent en termes de marquage appliqué au générateur enfant ; et
exécuter les générateurs et, lors de l'étape d'exécution des générateurs, le marquage utilisé dans le générateur parent est résolu avec le marquage utilisé dans le générateur enfant pour permettre au générateur parent d'utiliser l'interface de signal du générateur enfant,
au moins un des générateurs fonctionnant conformément au procédé selon la revendication 1.
